Europäisches Patentamt

European Patent Office

Office européen des brevets

(11) Publication number: **0 361 978**
**A2**

(12) # EUROPEAN PATENT APPLICATION

(21) Application number: **89310022.2**

(51) Int. Cl.⁵: **C09J 163/10 , H05K 3/30**

(22) Date of filing: **29.09.89**

(30) Priority: **30.09.88 US 252226**

(43) Date of publication of application:
**04.04.90 Bulletin 90/14**

(84) Designated Contracting States:
**BE CH DE ES FR GB IT LI**

(71) Applicant: **WESTINGHOUSE ELECTRIC CORPORATION**
**Westinghouse Building Gateway Center**
**Pittsburgh Pennsylvania 15222(US)**

(72) Inventor: **Su, Wei-Fant Anne**
**4334 Reynard Drive**
**Murrysville, PA 15668(US)**
Inventor: **Zucker, Richard S.**
**3254 Old Fence Road**
**Ellicott City, MD 21043(US)**

(74) Representative: **van Berlyn, Ronald Gilbert**
**23, Centre Heights**
**London, NW3 6JG(GB)**

(54) Improvements in or relating to resin compositions curable with ultraviolet light.

(57) A UV curable adhesive has been developed with good bond strength, good lap shear strength, rapid cure times, good thermal stability, and good insulating properties. The adhesive may be applied by silk screen printing and cured by UV in about 2 seconds. The adhesive may be used in automated surface mount technology for electronic circuit fabrication. The adhesive is a mixture of from 60 to 80% by weight, based on total composition weight, of a first resin which comprises an acrylate-epoxy oligomer having a molecular weight of from 2000 to 5000; from 4 to 10% of a second resin which comprises an acrylate-urethane oligomer; from 5 up to 20% of a third resin which comprises a cresol formaldehyde oligomer, liquid acrylate diluent for said resins; from 5 to 15% of a polyfunctional acrylate monomer; and from 1 to 5% of a UV photoinitiator. The compositions are applied to substrates such as printed wiring boards and cured with ultraviolet light to form an adhesion between electronic components and the substrate.

EP 0 361 978 A2

## IMPROVEMENTS IN OR RELATING TO RESIN COMPOSITIONS CURABLE WITH ULTRAVIOLET LIGHT

There are many applications for adhesive resins in the electronic industry such as surface mount component attachment (SMT), lid bonding, connector attachment, wire tacking, and coil termination. Adhesive resins with certain unique properties could be particularly attractive in attaching or fixing components to printed circuit boards. UV curable adhesives could provide a much simpler assembly procedure. Fast cure rates could make automation of electronic circuit assemblies attractive.

We have discovered ultraviolet radiation curable adhesive resins suitable for use in automated surface mount technology or electronic circuit fabrication, which has good bond strength, good lap shear strength, rapid cure time, cures shadow areas, good thermal stability, good insulating properties, and other properties that allow for a wide range of uses in the electronic industry.

Accordingly, the present invention resides in a UV curable resin composition characterized in that said composition comprises: (A) from 60 to 80% by weight, based on total composition weight, of a first resin which comprises (1) a first acrylate-epoxy oligomer having a molecular weight of from 2000 to 5000, prepared by reacting an anhydride or a diacid with a hydroxy acrylate followed by reaction with a bisphenol epoxy; (2) from 10 to 50% by weight, based on first resin weight, of a liquid acrylate diluent; and (B) from 4 to 10 percent by weight, based on total composition weight, of a second resin which comprises (1) an acrylate-urethane oligomer prepared by reacting a diisocyanate with a hydroxy acrylate to form a urethane followed by reaction of said urethane with caprolactam; and (2) from 10 to 50% by weight, based on second resin weight, of a liquid acrylate diluent; (C) from 5 to 20% by weight, based on total composition weight, of a third resin which comprises (1) a phenol formaldehyde oligomer; and (2) from 10 to 50% by weight, based on third resin weight, of a liquid acrylate diluent; (D) from 5 to 15% by weight, based on total composition weight, of a polyfunctional acrylate monomer; and (E) from 1 to 5% by weight, based on total composition weight, of a UV photoinitiator.

The invention also includes a method of attaching electronic components to a printed wiring board comprising the steps of (1) depositing a UV curable adhesive on either the board, the component, or both, (2) joining the board and the component so the adhesive is in contact with both, and (3) exposing the deposited adhesive to UV radiation to form a cured resinous bond.

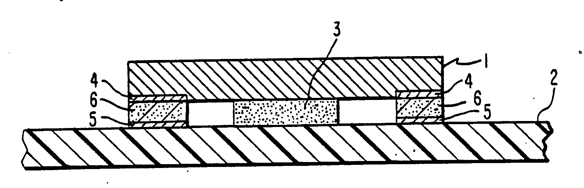

The figure illustrates a cross section of a electronic component bonded to a printed circuit board using an adhesive of the present invention.

Ultraviolet radiation curing technology is suited for the manufacturing industry to improve quality, increase productivity, and reduce volatile organic compound emission. Ultraviolet curing may provide high cure speeds and solventless resin systems. Ultraviolet curable resins usually can be cured at high speeds at room temperature on exposure to the appropriate UV wavelength. As a result, there is no damage to heat-sensitive components, and the materials have a long shelf life.

The adhesive of the present invention forms a one-part system and is compatible with in-line assembly. Specifically, the adhesive has a good bond strength, good insulating properties (volume resistivity of about $4.1 \times 10^{15}$ ohm-cm and surface resistivity of $1.9 \times 10^{15}$ ohm-sq.), good lap shear strength of about 1016 psi, good thermal stability, and rapid cure times of about 2 seconds.

The adhesive of the present invention may be applied by silk screen printing or automated syringe dispenser, and cured by ultraviolet radiation in a very short time of less than about 2 seconds. The rapid curing of the adhesive of the present invention enables automated mounting of components to the surfaces of printed wiring boards.

The figure illustrates a cross-sectional view of an electronic component or chip carrier 1 mounted or staked to a printed wiring board 2 with our cured insulating staking adhesive 3. The terminals 4 of the component are electrically connected to the printed wire conductive pattern traces 5 by conductive paste or solder 6.

Adhesives of the present invention require only the steps of screen printing, dot dispensing or otherwise depositing the staking adhesive where components are to be mounted on the PC board, placing the component on the adhesive and curing the adhesive with UV radiation.

The composition of the ultraviolet curable adhesive of the present invention is a mixture of (A) from about 60 to about 80% by weight, based on total composition weight, of a first resin which comprises an unsaturated epoxy oligomer having a molecular weight of from 2000 to 5000; (B) from about 4 to about 10% by weight, based on total composition weight, of a second resin which comprises an end-blocked acrylate-urethane oligomer; (C) from about 5 to 20% by weight, based on total composition weight, of a third resin which comprises a phenolformaldehyde oligomer; (D) from about 5 to about 15%, based on total composition weight, of a polyfunctional acrylate monomer; and (E) from about 1 to 5% by weight, based on

2

total composition weight, of a UV photoinitiator.

Optional components that may be added to the composition include: from about 0 to 10% by weight, based on total composition weight, of an adhesion promoter; from about 0 to 1% by weight, based on total composition weight of a thermally activated acrylate catalyst; from about 0 to 10% by weight, based on total composition weight of an epoxy thermal catalyst; and from about 0 to 1% by weight, based on total composition weight of a flow control agent.

Unlike other UV insulating adhesive compositions, the UV curable adhesive composition of this invention is a single component system, which means that it is not necessary to mix together two separate components immediately before the composition is used. This has the advantage for the user of saving an additional processing step and it avoids problems that can occur when the components are mixed in the wrong proportions or are improperly mixed. While the UV curable adhesive composition of this invention is only a single component, it nevertheless has a long shelf life, of at least 6 months.

The UV curable adhesive composition of this invention is a mixture of three resins, a polyfunctional acrylate monomer, a photoinitiator, and various optional components. It is related to the UV curable composition described in U.S. Patent Nos. 4,481,258; 4,357,219; and 4,317,858, all assigned to the assignee of this invention and all herein incorporated by reference. The components of the UV curable resin compositions of the present invention will now be described in detail as follows.

## FIRST RESIN

The first resin used in the UV curable adhesive composition of this invention is an unsaturated epoxy oligomer dissolved in a reactive acrylate diluent. The unsaturated epoxy oligomer is a compound having both ethylenic unsaturation and free epoxy groups, and a molecular weight of from 2000 to 5000. Oligomers having a lower molecular weight tend to form a bond that is too brittle, and oligomers having a higher molecular weight tend to make the composition too viscous. Acrylic unsaturation is preferred as it cures faster, but allylic or vinylic unsaturation can also be used.

An acrylate-epoxy oligomer, the preferred oligomer, can be made by acrylating an epoxy resin. For example, an epoxy resin can be acrylated in a two-step reaction. In the first step, a hydroxy acrylate, a compound having both acrylate groups and a single hydroxyl group, is reacted with an anhydride or a diacid to form an ester having a free carboxylic acid group and a free acrylate group. The reaction occurs between a carboxylic group of the diacid or anhydride, and a hydroxyl group of the hydroxy acrylate. Suitable hydroxy acrylates that can be used in this reaction include 2-hydroxyethyl acrylate (HEA), 3-hydroxypropyl acrylate, 2-hydroxy methacrylate, hydroxyethyl-beta-carboxyethyl acrylate, 3-hydroxypropyl methacrylate, hydroxyhexyl acrylate, hydroxyoctyl methacrylate, 2-hydroxypropyl acrylate, and 2-hydroxyethyl methacrylate. Di- and polyacrylates can also be used but they are not preferred as the resulting coatings may be too brittle. The preferred hydroxy acrylate is 2-hydroxyethyl acrylate because it is very reactive and results in a fast curing composition.

Suitable anhydrides that can be used include trimellitic anhydride, maleic anhydride, methylbicyclo [2.2.1] heptene-2,3-dicarboxylic anhydride, phthalic anhydride, methylenedic anhydride, and hexahydrophthalic anhydride. Di or polyanhydrides can also be used but they are not preferred because they may cause the composition to gel. Suitable diacids that can be used include terephthalic acid, isophthalic acid, oxalic acid, adipic acid, and succinic acid. Trimellitic anhydride (TMA) and maleic anhydride (MA) are preferred because they give a composition having a longer pot life and an adhesive bond that has better adhesion and better thermal stability.

The resulting ester is then reacted with an epoxy resin to form the acrylate-epoxy oligomer. The epoxy resin can have more than two epoxy groups, but diepoxides are preferred as more reactive polyepoxides may make the adhesive bond too brittle. The epoxy resin is preferably a bisphenol epoxy such as bisphenol A epoxy resin, bisphenol F epoxy, a bisphenol S epoxy resin or mixtures thereof as these epoxy resins promote the best adhesion of the coating to the surface. Bisphenol A epoxy resin is the least expensive and provides an excellent bond between a component and the substrate.

The epoxy resin should be soluble in a liquid acrylate which may conveniently be used as a liquid medium for the reactants. The liquid acrylate reacts later and becomes into the part of the bond. Examples of suitable liquid acrylates include phenol ethoxylate monoacrylate, tetrahydrofurfuryl methacrylate, cyclohexyl methacrylate, n-hexyl methacrylate, and 2-(2-ethoxyethoxy) ethyl acrylate. An inhibitor, such as benzoquinone, is included to deter reaction of the liquid acrylate during the epoxy resin-ester reaction. The preferred liquid acrylate is phenoxyethyl acrylate (PEA) because it is a good solvent for the oligomer.

Sufficient liquid acrylate should be used to give the resin a workable viscosity; from 10 to 50% (by first resin weight) of the liquid acrylate is usually sufficient.

Desirably, an epoxy catalyst, such as a tertiary amine, (e.g. triethanolamine (TEA)), is used to promote the reaction of the ester and epoxy resin to form the oligomer. Generally, at least 0.01% (all percentages herein are by weight unless otherwise indicated) catalyst (based on the weight of the first resin composition) is required, and more than 0.1% catalyst should be avoided as it makes the reaction difficult to control and may result in clouding.

The purpose of reacting the hydroxy acrylate with the anhydride or diacid is to produce an acrylate that will react with an epoxy group of an epoxy resin. Therefore, the hydroxy acrylate, the anhydride or diacid, and the epoxy resin should be used in such proportions that in the acrylate-epoxy oligomer all groups are reacted except for the acrylate group on the hydroxy acrylate and one epoxy group. The reaction proceeds with moderate heat at from 140 to 150° C and is finished when the acid number is less than 5.

Alternatively, the first resin may comprise an acrylate-epoxy oligomer by reacting a hydroxy acrylate, as described hereinbefore and maleic anhydride. The resulting ester is reacted with an epoxy such as a bisphenol epoxy and/or an epoxy novolac in a hydroxy acrylate containing an inhibitor such as benzoquinone. More than 10% novolac should be avoided to prevent gelling.

## SECOND RESIN

The second resin is an acrylated urethane oligomer, a compound that has both a free acrylate group and a urethane group. This oligomer can be prepared by reacting a diisocyanate with a hydroxy acrylate. Examples of suitable diisocyanates include:

4,4'-diisocyanato diphenyl 2,2-propane (4,4'-diphenyl-2,2-propane diisocyanate)
4,4'-diisocyanato diphenyl methane (4,4'-diphenylmethane diisocyanate)
4,4'-diisocyanato benzidine (4,4'-diphenyl diisocyanate)
4,4'-diisocyanato diphenyl sulfur (4,4'-diphenylsulfide diisocyanate)
4,4'-diisocyanato diphenyl sulfone (4,4'-diphenylsulfone diisocyanate)
4,4'-diisocyanato diphenyl ether (4,4'-diphenylether diisocyanate)
4,4'-diisocyanato diphenyl 1,1-cyclohexane (4,4'-diphenyl-1,1-cyclohexane diisocyanate)
oxides of methyl- and of bis (meta-isocyanato-phenyl) phosphine(methyl and bis(meta-phenyl isocyanate) phosphine oxide)
diisocyanato 1,5-naphthalene (1,5-naphthalene diisocyanate)
meta-phenylene diisocyanate
tolylene diisocyanate (toluylene diisocyanate or toluene diisocyanate)
3,3'-dimethyl diphenyl 4,4'-diisocyanate (dimethyl 3,3'-diisocyanato 4,4'-diphenylene)
3,3'-dimethoxy diphenyl 4,4'-diisocyanate (dimethoxy 3,3'-diisocyanato 4,4'-diphenylene)
meta-xylylene diisocyanate
para-xylylene diisocyanate
4,4'-dicyclohexylmethane diisocyanate (diisocyanato 4,4'-dicyclohexyl methane)
hexamethylene diisocyanate
dodecamethylene diisocyanate
2,11-dodecane diisocyanate (diisocyanato 2,11-dodecane)
bis(para-phenylene isocyanate 1,3,4-oxadiazole) para-phenylene
bis(para-phenylene isocyanate), 1,3,4-oxadiazole
bis(meta-phenylene isocyanate), 1,3,4-oxadiazole
bis(meta-phenylene isocyanate)4-phenyl 1,2,4-triazole
bis (4-paraphenylene isocyanate thiazole 2-yl) metaphenylene
(2-phenylene)5,4'-benzimidazole diisocyanate
(2-phenylene)5,4'-benzoxazole diisocyanate
(2-phenylene)6,4'-benzothiazole diisocyanate
2,5-bis(2-phenylene isocyanate benzimidazole-6-ene) 1,3,4-oxadiazole
bis(para-phenylene isocyanate-2-benzimidazole-6-ene)
bis(para-phenylene isocyanate-2-benzoxazole-6-ene)

The preferred diisocyanate is tolylene diisocyanate (TDI) because it is inexpensive and has been found to work well.

Suitable hydroxy acrylates can be selected from the hereinabove provided list. The preferred hydroxy acrylate is 2-hydroxyethyl acrylate because it results in a faster reaction. In this reaction, an isocyanate group of the diisocyanate reacts with the hydroxyl group of the hydroxy acrylate to produce a urethane. This reaction is conducted in the presence of an inhibitor (i.e., a free radical scavenger) such as naphthoquinone, phenanthraquinone, 2,6-di-tert-butyl-4-methyl phenol, benzoquinone, hydroquinone, or methylquinone to prevent the spontaneous polymerization of acrylic groups. At least 0.01% inhibitor (based on the total weight of the second resin) should be used. If less inhibitor is used, the oligomer may gel. However, more than 0.1% of the inhibitor should be avoided as the UV reactivity may then be low.

The reaction of the diisocyanate with the hydroxy acrylate proceeds readily at about 60°C for 1 hour. A proportion of 1 equivalent of diisocyanate to 1 equivalent of the hydroxy acrylate should be used so that the resulting urethane compound has a free isocyanate group. That isocyanate group is then reacted with caprolactam to produce a urea linkage. The reaction with caprolactam can be performed at about 100°C until no isocyanate peak is observed in an infra red absorption spectrometer. From 10 to 50% by weight, based on the weight of the second resin, of a liquid acrylate is then added as a diluent to make the oligomer less viscous. Suitable liquid acrylates may be found in the list provided hereinabove, and PEA is again preferred. A description of first and second resins can be found in U.S. Patent Specification 4,481,258.

## THIRD RESIN

The third resin is a phenol-formaldehyde oligomer based on a cresol. It increases the adhesion characteristics of the composition. This oligomer can be prepared by reacting a cresol with a formaldehyde. The preferred cresol is m,p-cresol and that the formaldehyde is about 40% aqueous formaldehyde. Salicylic acid is then added. This reaction is conducted in the presence of a catalyst, such as organic amines and inorganic hydroxides.

The reaction of the cresol and aqueous formaldehyde proceeds by heating at reflux for about one hour. A proportion of up to 2 moles of the cresol to 1 mole of the formaldehyde should be used to control the molecular weight. The cresol-formaldehyde is then reacted with salicylic acid at a temperature of about 60° to 90°C and a pressure of about 50 mm. Hg. until a Gardner viscosity of Z-4 is obtained. From 10 to 50% by weight, based on the weight of the third resin, of a liquid acrylate is then added to the oligomer to stop the reaction and reduce viscosity. Suitable liquid acrylates may be found in the list provided herein above, and PEA is again preferred. A description of the third resin and its preparation can be found in column 5 of U.S. Patent Specification 4,317,858, all of the patent herein incorporated by reference.

## POLYFUNCTIONAL ACRYLATE MONOMER

The compositions include a polyfunctional acrylate monomer. It is preferred that the polyfunctonal acrylate monomer be difunctional or trifunctional, as monofunctional acrylates have a slow cure rate and tetrafunctional acrylates have a brittle adhesive bond. This monomer reduces the viscosity and increases the curing rate and the adhesion of the coating to the substrate surface.

Suitable difunctional acrylate monomers include 1,3-butylene glycol diacrylate, 1,4-butandiol diacrylate, diethylene glycol diacrylate, 1,6-hexanediol diacrylate, 2,2-dimethylpropane-1,3-diacrylate, tetraethylene glycol diacrylate (TEGDA), and tripropylene glycol diacrylate.

Suitable trifunctional acrylate monomers include trimethylpropane diacrylate, pentaerythritol triacrylate, ethoxylated trimethylol propane triacrylate, and glyceryl propoxy triacrylate (GPTA).

The polyfunctional acrylate monomer may be mixtures of difunctional monomers and trifunctional monomers. It is preferred that the polyfunctional acrylate monomer is TEGDA, GPTA, or mixtures thereof. These monomers reduce viscosity and increase bond strength.

Tetraethyleneglycol diacrylate is preferred because it provides adequate cure speed, viscosity, and flexibility.

## PHOTOINITIATOR

Also required in the composition is a photoinitiator. The photoinitiator is a compound that generates free radicals when exposed to ultraviolet light. The free radicals then initiate the free radical chain polymerization of the acrylate groups in the composition. Photoinitiators are well known to those skilled in the art. They are often mixtures of several different compounds and are frequently proprietary.

The photoinitiators suitable for use in the present invention include glyoxalate derivatives, benzoin ether derivatives, alpha-acryloxime ester derivatives, acetophenone derivatives, and ketone-amine combinations.

Examples of suitable photoinitiators include: isobutyl benzoin ether (V-10, a product of Stauffer Chemical), isopropyl benzoin ether, benzoin ethyl ether, benzoin methyl ether, 1-phenol-1,2-propane-dione-2-(O-ethoxycarbonyl) oxime, 2,2-dimethoxy-2-phenyl-acetophenone (IRG-651, a product of Ciba Geigy), benzyl hydroxy-cyclohexyl phenyl ketone, diethoxyacetophenone, 2-hydroxy-2-methyl-1-phenyl-propane-1-one, and methyphenyl glyoxalate (V-55, a product of Stauffer Chemical).

The ketone-amine combination is preferably a primary or secondary, aliphatic or aromatic amine or ketones which include benzophenone, chlorothioxanthone, 2-chlorothioxanthone, isopropyl thioxanthone, 2-methylthioxanthone, chlorine functional substituted benzophenone, halogen substituted alkyl-arylketones, wherein halogen is chlorine, bromine, or iodine. The photoinitiator may be mixtures of the above-described suitable photoinitiators.

## ADHESION PROMOTER

Suitable adhesion promoters may be present in amounts of about 0-1% by weight, and preferably about 0.01 to 0.1% by weight, of the total composition weight. Phosphate or mercaptan derivatives, such as acrylated mercaptan (EB19-6375, a product of Radcure, Inc.) or acrylated phosphate ester (EB-19-6170, a product of Radcure, Inc.) and mixtures thereof may be added to the adhesive composition.

## THERMAL CATALYST

In order to ensure subsequent adequate cure for the shadow areas, i.e., unexposed to the ultraviolet light, various thermal catalysts may be used. Post thermal cure catalysts provide curing in areas shadowed by components on the printed wiring boards. Suitable post cure thermal acrylate and/or epoxy thermal catalysts include t-butyl perbenzoate (t-Bp), a product of Lucidol; triphenyl tin chloride, a product of Fisher; Catechol (a product of Aldrich Chemical Co.) triethanolamine titanate (WT-17, Westinghouse Electric Corporation, EMD, Manor, PA) and the like.

## OTHER OPTIONAL COMPONENTS

Various other compounds may be included in the composition as desired including, for example, dyes or pigments that are UV transparent for easy inspection in the assembly line and flow control agents for easy application and reduced moisture permeability. Suitable flow control agents include alkylphenol ethoxylate, alcohol ethoxylate, fluorinated alkyl alkoxylate and ether sulfate.

## PROPORTIONS

The compositions are prepared by thoroughly mixing the various components. The amount of the first resin should be from 60 to 80% (based on total composition weight) as less may make the resulting cured bond too brittle and more may make the adhesive composition too viscous. A preferred amount of the first resin is from 65 to 75%. The amount of the second resin should be from 4 to 10% because more than 10% may result in a brittle coating. The third resin is present in an amount from 5 to 20% by weight of total composition. The percentage of polyfunctional acrylate monomer is from about 5 to 15%. The polyfunctional acrylate monomer provides viscosity control, cure speed, and adhesion of the resin to the substrate. The photoinitiator should be present in an amount of at least 1% as less may result in a slow reaction. More

6

than 5% may result in poor properties, such as toughness and hardness. Thermal catalysts are preferably present in amounts up to 1% for acrylate thermal catalysts and up to 10% for epoxy thermal catalysts. These catalysts provide a thermal cure in areas unexposed to UV light and, therefore, not cured.

The adhesive may be applied to a substrate by screen printing, dot dispensing, or almost any other technique. After it is applied to the substrate and the component is placed thereover, it is exposed to ultraviolet light (Fusion System's Model F440 D Bulb, 300 watt/in) for a few seconds, typically from 2 to 4 seconds, which results in the free radical chain polymerization of the unreacted acrylate groups.

The invention will now be illustrated with reference to the following Examples:

## EXAMPLES

### Preparation Of First Resin

Into a 600 ml stainless steel beaker equipped with a stirrer, thermometer, and heating mantle, was charged 192.1 grams TMA, 116.1 grams HEA, and 2.6 grams benzoquinone. The reactants were heated to 120°C for 1.5 hours.

A five liter reaction flask equipped with a stirrer, thermometer, nitrogen sparge, and heating mantle was charged with 66.0 grams of the above-made reaction product along with 1949.0 grams of a bisphenol A epoxy resin having an epoxy equivalent weight of 2000, sold by Shell Chemical Co. under the trade designation "Epon 1007F," 1992 grams PEA, and 1.19 grams of triethanolamine. The reactants were heated to 140 to 150°C for 1.5 hours to an acid number below 5.

### Preparation Of Second Resin

A 1 liter reaction flask equipped with a stirrer, thermometer, nitrogen sparge, and heating mantle was charged with 348.2 grams TDI (80% of the 2,4 isomer and 20% of the 2,6 isomer), and 0.12 grams benzoquinone. Keeping the exotherm temperature below 60°C, 232.2 grams of HEA was added portion-wise. The reaction was continued at 60°C for 1 hour, and 226.2 grams of caprolactam was added. The reaction was continued at 100°C for 1 hour and 201.5 grams of PEA was added.

### Preparation Of Third Resin

To a two liter reaction flask equipped with a reflux condenser is added 1144.0 grams m,p-cresol, 596.0 grams 40% aqueous formaldehyde, and 22.4 grams triethanolamine. The mixture is heated at reflux for one hour and then 20.8 grams salicyclic acid is added. The mixture is heated at 60° to 90°C, at a pressure of 50 millimeters of mercury until a Gardner viscosity of Z-4 is obtained. Then 215.3 grams phenoxyethyl acrylate is added and the mixture is cooled.

The Tables below illustrate certain embodiments of the adhesive of the present invention.

TABLE 1

| COMPOSITION OF OLIGOMER FOR UV CURABLE ADHESIVES | |
|---|---|
| Component | Composition, Moles/Component |
| First Resin | 1/HEA, 1/TMA, 2/Epon 1007F; in 50% PEA (by weight) |
| Second Resin | 1/Caprolactam, 1/TDI, 1/HEA; in 20% PEA |
| Third Resin | 1.33/m/p Cresol (90/10), 1/HCHO; in 10% PEA |

TABLE 2

| COMPOSITION OF UV CURABLE ADHESIVES | |
|---|---|
| Formulation Number | Composition, Weight % |
| A | 69.65% first resin, 8.71% second resin, 8.71% third resin, 8.71% TEGDA, 2.09% Irg 651, 2.09% V-10, 0.5% EB19-6375 |
| B | 69.30% first resin, 8.67% second resin, 8.6% third resin, 8.6% TEGDA, 2.08% Irg 651, 2.08% V-10, 0.50% tBp, 0.05% EB19-6375 |
| C | Same as B, except that Irg 651 was used in place of V-10. |

TABLE 3

| DEFINITIONS | |
|---|---|
| HEA: | 2-hydroxy ethyl acrylate |
| TMA: | Trimellitic Anhydride |
| Epon 1007F: | Bisphenol A epoxy resin with an epoxy equivalent weight of 2000, Shell Chemical |
| PEA: | Phenoxy ethyl acrylate |
| TDI: | Toluene diisocyanate |
| HCHO: | Formaldehyde |
| TEGDA: | Tetraethylene glycol diacrylate |
| Irg 651: | 2,2-dimethoxy-2-phenyl acetophenone |
| V-10: | Isobutyl benzoin ether |
| EB19-6375: | Acrylated mercaptan |

Tables 4 and 5 disclose certain physical properties of the adhesives of the present invention.

Formulations A, B, and C have shown the highest bond strengths among formulations tested after UV cure. The package cannot break loose from the board without the board or the package being damaged after thermal post cure at 125°C for one hour, so that the adhesive is cured throughout the package after thermal post cure. In general, the bond strength of the UV adhesive is dependent on the size of the package. The smaller the package, the higher the bond strength is as shown in Table 4.

TABLE 4

| PULL STRENGTH[a] OF CURABLE ADHESIVES | | |
|---|---|---|
| (1500 g/cm² Minimum Pull Strength Required) | | |
| Bond Strength[b] (g/cm²) at Package Size After UV Cure | | |
| Formulation Number | 0.806 cm² (1/2x1/4 in²) | 1.511 cm² (3/8x5/8 in²) |
| A | 4280.893 | 2884.447 |
| B | 3041.687 | 2325.585 |

[a]Pull strength was measured by Chatillon Gauge.
[b]Average of five measurements.

8

TABLE 5

| Formulation: | C |
|---|---|
| No. Component: | 1 |
| Consistency: | Heavy Thixotropic Paste |
| Pot Life: | >12 months |
| Cure Schedule: | 2-6 sec @ R.T. with UV |
| Tg (°C): | 75 (UV/4 sec @ R.T.) |
| | 119 (UV/4 sec + 15 min @ 125°C |
| Lap Shear Strength (psi) (ASTM D1002): | 1016[1] |
| Pull Bond Strength $(g/cm^2)^2$ | 3200 |
| Volume Resistivity (ohm-cm): | $4.1 \times 10^{15}$ |
| Surface Resistivity (ohm-sq): | $1.9 \times 10^{15}$ |
| Dielectric Constant (1 kHz): | 4.4 |
| Dissipation Factor (1 kHz): | 0.0279 |
| Dielectric Strength (V/Mil): | 1099 |
| Cross Hatch Adhesion (ASTM D3359) | FR-4 100% |
| | Tin 100% |
| | Polycarbonate 100% |
| | Aluminum 100% |

[1]Sample cured for 1 hour at 180°C (no UV cure).
[2]Adhesive pull bond strength between a 3/8" x 1/4" chip and printed wiring board was determined by a Chatillon gauge.

The adhesives were applied on FR-4 epoxy laminate boards by screen printing or automated syringe dispensing. They were cured by exposure to Fusion Systems' lamps Model F440 with H and D bulbs at 20 ft/min, which was equivalent to 2 seconds UV exposure. The adhesive required less than about 2 seconds to cure.

LAP SHEAR STRENGTH

The lap shear strength of the staking adhesives was tested according to the ASTM D1002 method; it exhibited strength of 1016 psi. Because the aluminum substrate of the samples blocks off the UV radiation to the adhesive, all the samples were cured thermally and with loading 3-10 psi on top of the samples. The staking adhesive exhibited good bond strength.

THERMAL PROPERTIES OF ADHESIVES

The thermal stabilities of the adhesives were evaluated by TGA. The results are shown in Table 6.

TABLE 6

| THERMAL STABILITY OF UV CONDUCTIVE ADHESIVES BY TGA | | | |
|---|---|---|---|
| | Temperature (°C) at which weight loss (%) occurs | | |
| Sample | 5% | 10% | 15% |
| Formulation C | 155 | 195 | 275 |

9

The temperature for a 10% weight loss of the conductive adhesive was 195°C. The glass transition temperature (Tg) of the staking adhesive was studied by TMA. It was 75°C for UV cure only and 119°C for UV plus thermal post-cure at 125°C for 15 minutes.

It will be appreciated that the above-described invention provides a UV curable adhesive resin with good bond strength, good lap shear strength, good thermal stability, a quick cure and good insulating properties. The staking adhesive can hold components on a pwb without influencing the electric characteristics of pwb and their components. This adhesive may be applied by silk screen printing or automatic syringe dispenser to either one or both surfaces to be joined and cured by UV in a short time. The adhesive of the present invention is especially useful in automated surface-mount technology for electronic circuit fabrication. The staking adhesive of the present invention may be used in conjunction with a conductive adhesive and/or conformal coatings to provide a finished printed wiring board product.

Whereas particular embodiments of the invention have been described above for purposes of illustration, it will be appreciated by those skilled in the art that numerous variations of the details may be made without departing from the invention as described in the appended claims.

## Claims

1. A UV curable liquid adhesive resin composition characterized in that said composition comprises:

(A) from 60 to 80% by weight, based on total composition weight, of a first resin which comprises
(1) a first acrylate-epoxy oligomer having a molecular weight of from 2000 to 5000, prepared by reacting an anhydride or a diacid with a hydroxy acrylate followed by reaction with a bisphenol epoxy;
(2) from 10 to 50% by weight, based on first resin weight, of a liquid acrylate diluent; and
(B) from 4 to 10 percent by weight, based on total composition weight, of a second resin which comprises
(1) an acrylate-urethane oligomer prepared by reacting a diisocyanate with a hydroxy acrylate to form a urethane followed by reaction of said urethane with caprolactam; and
(2) from 10 to 50% by weight, based on second resin weight, of a liquid acrylate diluent;
(C) from 5 to 20% by weight, based on total composition weight, of a third resin which comprises
(1) a phenol formaldehyde oligomer; and
(2) from 10 to 50% by weight, based on third resin weight, of a liquid acrylate diluent;
(D) from 5 to 15% by weight, based on total composition weight, of a polyfunctional acrylate monomer; and
(E) from to 5% by weight, based on total composition weight, of a UV photoinitiator.

2. A composition according to claim 1 characterized in that the first acrylate-epoxy oligomer is prepared from 2-hydroxyethyl acrylate, trimellitic anhydride, and a bisphenol A epoxy resin.

3. A composition according to claim 1 characterized in that the diisocyanate is tolylene diisocyanate and the hydroxy acrylate is 2-hydroxyethyl acrylate.

4. A composition according to claim 1 characterized in that the liquid acrylate is phenoxyethyl acrylate.

5. A composition according to claim 1 characterized in that the polyfunctional acrylate monomer is tetraethyleneglycol diacrylate.

6. A composition according to claim 1 characterized in that the UV photoinitiator is selected from the group consisting of 2,2-dimethoxy-2-phenyl acetophenone, isobutyl benzoin ether, and mixtures thereof.

7. A composition according to claim 1 characterized in that the composition includes a thermal catalyst.

8. A composition according to claim 1 characterized in that the thermal catalyst is selected from the group consisting of an acrylate thermal catalyst, an epoxy thermal catalyst and mixtures thereof.

9. A method of attaching electronic components to a printed wiring board comprising the steps of (1) depositing a UV curable adhesive on either the board, the component, or both, (2) joining the board and the component so the adhesive is in contact with both, and (3) exposing the deposited adhesive to UV radiation to form a cured resinous bond.

10. The method of claim 9 wherein the UV curable adhesive is the composition of claim 1.

11. A substrate coated with dot of a resin composition cured with ultraviolet light characterized in that said composition prior to curing as claimed in any of claims 1 to 8.

12. A coated substrate according to claim 11, characterized in that the substrate is a printed wiring board.